# EUROPÄISCHE PATENTSCHRIFT

(11) **EP 1 583 408 B1**
(45) Veröffentlichungstag und Bekanntmachung des Hinweises auf die Patenterteilung: **28.05.2008**
(21) Anmeldenummer: 04008070.7
(22) Anmeldetag: 02.04.2004
(51) Int. Cl.: H05K 7/14

(54) **Arretierung von austauschbaren Baugruppen mit automatischer Zwangsabschaltung**
Locking of exchangeable modules with forced automatic disconnection
Verrouillage de modules échangeable avec déconnexion forcé automatique

(43) Veröffentlichungstag der Anmeldung: 05.10.2005
(73) Patentinhaber: SIEMENS AKTIENGESELLSCHAFT, 80333 München (DE)
(72) Erfinder: Brada, Ralf, 99625 Kölleda (DE); Bräunlich, Michael, 09117 Chemnitz (DE)

(56) Entgegenhaltungen:
- EP-A- 0 599 551
- DE-A- 3 147 056
- DE-A- 19 807 710
- US-A1- 2002 182 902
- US-B1- 6 215 204

## Beschreibung

Die Erfindung betrifft ein Terminalmodul zur Aufnahme mindestens einer Baugruppe, insbesondere eines Stromversorgungsmoduls.

Elektrische Anlagen, Geräte und Betriebsmittel werden, um sie besser an die Erfordernisse des Anwenders anpassen zu können, oft modular, redundant und austauschbar aufgebaut. Ist das modular aufgebaute Gerät eine elektrische Steuerung, wird eine sinnvolle Modularität zumeist mit einer Aufteilung in passive (nicht störanfällige) Terminalmodule und aktive (daher auch störanfällige) Baugruppen bzw. Elektronikmodule erreicht. Durch eine Aneinanderreihung mehrerer Terminal- und Elektronikmodule wird letztlich die vom Kunden gewünschte Funktion der Steuerung erreicht.

Ebenso werden die Stromversorgungskomponenten für die elektronische Steuerung modular, redundant und austauschbar aufgebaut.

Um einen ungestörten Betrieb gewährleisten zu können, müssen die störanfälligen Baugruppen bzw. Elektronikmodule, sowie die Stromversorgungsmodule (PS-Module) auch unter Last austauschbar und montierbar sein. Die Anlage bzw. Teile der Anlage werden vor dem Wechsel der Baugruppen bzw. Elektronikmodule, bzw. PS-Module (im Folgenden zusammengefasst als Baugruppe) also nicht abgeschaltet. Ist aber eine Baugruppe beispielsweise über einen Stromkreis so mit einen Terminalmodul verbunden, dass beim Stecken oder Ziehen der elektrischen Baugruppe eine Funkenbildung am Steckverbinder zwischen der elektrischen Baugruppe und dem Terminalmodul nicht ausgeschlossen werden kann, so sind besondere konstruktive Maßnahmen vorzusehen, die eine derartige Funkenbildung verhindern.

Eine Möglichkeit besteht darin, die Verriegelung der Baugruppe auf dem Terminalmodul so auszulegen, dass beim Betätigen des Verriegelungsmechanismus zwangsläufig eine interne Abschaltung der Baugruppe erfolgt. Hierbei muss gleichzeitig gewährleistet sein, dass in der Zeit zwischen der internen elektrischen Abschaltung und dem Lösen der Baugruppe genügend Zeit vergeht, um noch in Kapazitäten oder Induktivitäten gespeicherte Energien sicher abzubauen. Beim Stecken der elektrischen Baugruppe muss dieser Mechanismus umgekehrt funktionieren, d.h. das interne Zuschalten der Baugruppe darf erst nach Abschluss des Steckvorganges möglich sein.

Aus der Anmeldung mit der Anmeldenummer 03023213.6 ist ein sicherheitstechnischer Verriegelungsmechanismus für Baugruppen mittels eines Riegels bekannt, bei dem der elektrische Kontakt während des Steckens und Ziehens zwangsläufig geöffnet wird. Der Verriegelungsmechanismus und die beim Ziehen und Stecken notwendige Abschaltung findet bei dieser Lösung in der Baugruppe statt.

Eine derartige Lösung ist nicht realisierbar, wenn konstruktive Besonderheiten der Baugruppe vorliegen, die eine in die Baugruppe integrierte Implementierung des Riegelmechanismus und der Zwangsabschaltung unmöglich machen, wie etwa die Tatsache, dass die Baugruppe gekapselt bzw. vergossen ist.

Aus der US 6215204 B1 ist eine Steuereinheit zur Aufnahme einer Schalteinheit bekannt, wobei der elektrische Kontakt durch Arretierung der Schalteinheit in der Steuereinheit hergestellt wird.

Die Aufgabe der vorliegenden Erfindung ist, einen Arretierungsmechanismus für Baugruppen anzugeben, bei dem die Verriegelung und die elektronische Zwangsabschaltung außerhalb der Baugruppe erfolgt.

Die Aufgabe wird gelöst durch Terminalmodul zur Aufnahme mindestens einer Baugruppe, insbesondere eines Stromversorgungsmoduls, mit einem verschiebbaren Riegel zur mechanischen Arretierung der Baugruppe im Betriebszustand, wobei der Riegel beim Ziehen und/oder Stecken der Baugruppe gegen eine durch ein Widerlager erzeugte Kraft linear verschiebbar ist und mit elektrischen Kontakten für die Baugruppe, wobei die elektrischen Kontakte mit dem Riegel derart verbunden sind, dass die elektrischen Kontakte beim Ziehen und/oder Stecken der Baugruppe geöffnet werden.

Der Erfindung liegt die Erkenntnis zugrunde, dass ein möglichst einfaches Einstecken und Ziehen bzw. Ein- und Aufschwenken einer Baugruppe auf ein Terminalmodul gewährleistet sein sollte. Im montierten Zustand sollte hierbei eine formschlüssige Verbindung zwischen Baugruppe und Terminalmodul gewährleistet sein, so dass eine sichere Befestigung der Baugruppe garantiert ist. Gleichzeitig sollte die Baugruppe relativ einfach und zügig demontiert werden können.

Gleichzeitig ist gewährleistet, dass es während des Ziehens und Steckens der Baugruppe bzw. des PS-Moduls, was ohne Abschaltung der Versorgungsspannung erfolgen soll, an den stromführenden Stiften eines Steckverbinders, welcher Baugruppe bzw. PS-Modul und Terminalmodul elektrisch miteinander verbindet, nicht zur Entstehung eines Lichtbogens oder Zündfunkens kommt .

In der vorliegenden Erfindung werden diese Anforderungen dadurch vorteilhaft gelöst, dass ein verschiebbarer Riegel, am Terminalmodul angebracht ist, welcher über einen Schaltnocken gesteuert wird und im Betriebszustand die mechanische Arretierung der Baugruppe bzw. des PS-Moduls gewährleistet. Der Riegel ist außerdem mit den elektrischen Kontakten für die Baugruppe bzw. das PS-Moduls derart verbunden, dass das verschieben des Riegels während des Einschwenkvorgangs bzw. des Abschwenkens automatisch zur Abschaltung der elektrischen Kontakte führt. Dadurch wird ein oder werden mehrere nicht funkende Hilfsstromkreise in der Baugruppe bzw. dem PS-Modul unterbrochen, die ihrerseits wiederum den oder die möglicherweise funkenden Hauptstromkreise sicher unterbrechen.

Hierbei wird beim Ziehen und Stecken der Riegel gegen ein Widerlager, beispielsweise eine oder mehrere Druckfedern bewegt.

Eine weitere vorteilhafte Ausbildung der Erfindung ist dadurch gekennzeichnet, dass ein Widerlager, insbesondere eine Druckfeder vorgesehen ist, wobei der Riegel gegen eine durch das Widerlager erzeugte Kraft verschiebbar ist. Das Widerlager sorgt dafür, dass sich der Riegel im Fall, dass keine Baugruppe bzw. kein PS-Modul eingeschwenkt ist, in einer definierten Position befindet, in der bestimmte Elemente, beispielsweise Schrauben für eine Klemme, zur Bedienung freiliegen.

Außerdem ist die Druckfeder zur Ausübung einer Kraft auf den Riegel derart vorgesehen ist, dass die notwendigen Arretierungskräfte für eine kraft- und formschlüssige Verbindung der Baugruppe bzw. des PS-Moduls mit dem Terminalmodul erzeugt werden. Zusätzlich sorgt die Druckfeder bzw. das Widerlager während des gesamten Einschwenkvorgangs für eine definierte Position des Riegels.

Eine weitere vorteilhafte Ausbildung der Erfindung ist dadurch gekennzeichnet, dass der Riegel mindestens eine erste Öffnung zur Aufnahme eines Rasthakens einer Baugruppe aufweist, wobei die Öffnung derart ausgebildet ist, dass das Aus- bzw. Einführen des Rasthakens beim Ziehen und/oder Stecken der Baugruppe die Verschiebung des Riegels bewirkt. Die Ab- und Zuschaltung der elektrischen Kontakte und die Verrastung des aufgeschwenkten Moduls wird somit über eine Nockenbahn realisiert.

Eine seitliche Verschiebung der Baugruppe wird durch formschlüssige Geometrien erreicht.

Eine weitere vorteilhafte Ausbildung der Erfindung ist dadurch gekennzeichnet, dass Befestigungsmittel zur Befestigung des Terminalmoduls auf einer Tragschiene vorgesehen sind, wobei die Befestigungsmittel derart angeordnet sind, dass der Riegel nur im befestigten Zustand verschiebbar ist. Ein Verschieben des Riegels kann also erst erfolgen, wenn das Terminalmodul an der Tragschiene befestigt ist. Dies gewährleistet einen Schutz vor Fehlmontage. Die Befestigungsmittel sind hierbei beispielsweise als Schrauben ausgebildet.

Vorteilhafterweise weist der Riegel zweite Öffnungen zur Bedienung der Befestigungsmittel auf. Der Riegel kann dann erst verschoben werden, wenn beispielsweise die Schrauben fest angezogen sind. Hierzu besitzt der Riegel eine Form, die das Gleiten über die nicht befestigten Schrauben verhindert. Wenn der Riegel nicht verschoben werden kann, ist auch das Aufschwenken bzw. Stecken einer Baugruppe unmöglich. Die gesamte Konstruktion sichert somit eine korrekte Bedienung.

Eine weitere vorteilhafte Ausbildung der Erfindung ist dadurch gekennzeichnet, dass der Riegel dritte Öffnungen aufweist, wobei die dritten Öffnungen nur im befestigten Zustand, wenn der Riegel verschiebbar ist, zugänglich sind und wobei die dritten Öffnungen zur Bedienung einer elektrischen Anschlussklemme vorgesehen sind. Im Betriebszustand ist die gesteckte Baugruppe zur Abdeckung der dritten Öffnungen vorgesehen. Somit kann im Betriebszustand an den Klemmanschlüssen keine Manipulation vorgenommen werden.

Eine Manipulation an diesen Klemmen würde zu einer Funkenbildung führen. Der Gesetzgeber schreibt vor, dass die Klemmen abgedeckt werden müssen. Diese Abdeckung muss einen sichtbaren Sicherheitshinweis beinhalten in der Art: " Achtung! Nicht unter Spannung öffnen!" Dieser Hinweis ist auch auf dem Riegel aufgedruckt. Da der Riegel erst verschoben werden muss, um an die Klemmen zu gelangen, ist die Forderung erfüllt. Auch in der dem Betriebszustand vorangehenden Phase - Verdrahtung/Inbetriebnahme und auch bei gezogener Stromversorgung (z.B. beim Austausch eines defekten Stromversorgungsmoduls) kann an den Klemmen nicht direkt etwas getan werden

Im Folgenden wird die Erfindung anhand der in den Figuren dargestellten Ausführungsbeispiele näher beschrieben und erläutert. Es zeigen:
- FIG 1: ein Terminalmodul mit verschiebbarem Riegel,
- FIG 2: ein Terminalmodul ohne Abdeckung mit Riegel
- FIG 3: ein Terminalmodul ohne Abdeckung und ohne Riegel,
- FIG 4: ein Terminalmodul mit geschlossenen Kontakten,
- FIG 5: ein Terminalmodul mit geöffneten Kontakten,
- FIG 6: eine beispielhafte Ausgestaltung der Befestigungs mittel des Terminalmoduls,
- FIG 7: eine beispielhafte Ausgestaltung der Öffnungen im Riegel zum Zugang zu den Befestigungsmitteln,
- FIG 8: befestigtes Terminalmodul in Lateralansicht,
- FIG 9: befestigtes Terminalmodul in Draufsicht,
- FIG 10: Terminalmodul mit aufgerasteter Baugruppe,
- FIG 11: Baugruppe mit Rasthaken
- FIG 12: ein Schaltdiagramm zur Wiedergabe des Schaltwegs sowie der Schaltposition.

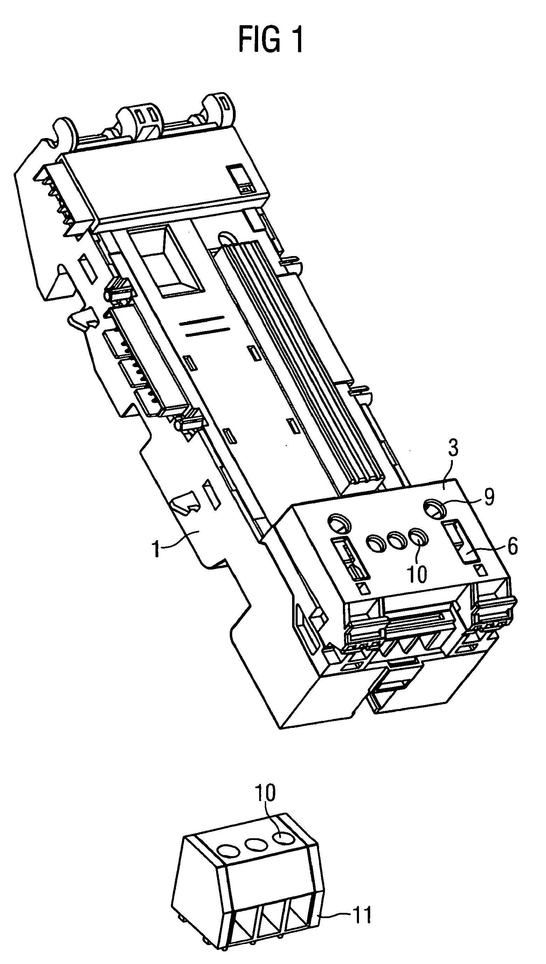

FIG 1 zeigt ein Terminalmodul 1 mit einem verschiebbaren Riegel 3. Der Riegel 3 weist eine erste Öffnung 6 zur Aufnahme eines Rasthaken 7 einer Baugruppe 2 oder eines Stromversorgungsmoduls (PS-Modul) auf. Weiterhin weist der Riegel 3 zweite Öffnungen 9 zur Bedienung von Befestigungsmitteln 8, beispielsweise einer Schraube, auf. Es können ein oder mehrere derartige Öffnungen 9 vorhanden sein, so dass eine unterschiedliche Anzahl von Befestigungsmitteln 8 verwendet werden kann. Die Befestigungsmittel 8 dienen zur Befestigung des Terminalmoduls 1 auf einer Tragschiene. Der Riegel 3 weist weiterhin dritte Öffnungen 10 zur Bedienung einer Anschlussklemme 11 auf. Mit dem Riegel 3 sind Abschaltkontakte 4 starr verbunden.

Ein Verschieben des Riegels 3 bewirkt gleichzeitig ein Verschieben der Abschaltkontakte 4. Beim Ziehen oder Stecken bzw. beim Ein- oder Aufschwenken einer Baugruppe 2 oder eines Stromversorgungsmoduls 2 werden die elektrischen Kontakte 4 zwangsläufig geöffnet. Gleichzeitig wird eine Arretierung der Stromversorgung PS im Betriebszustand gewährleistet.

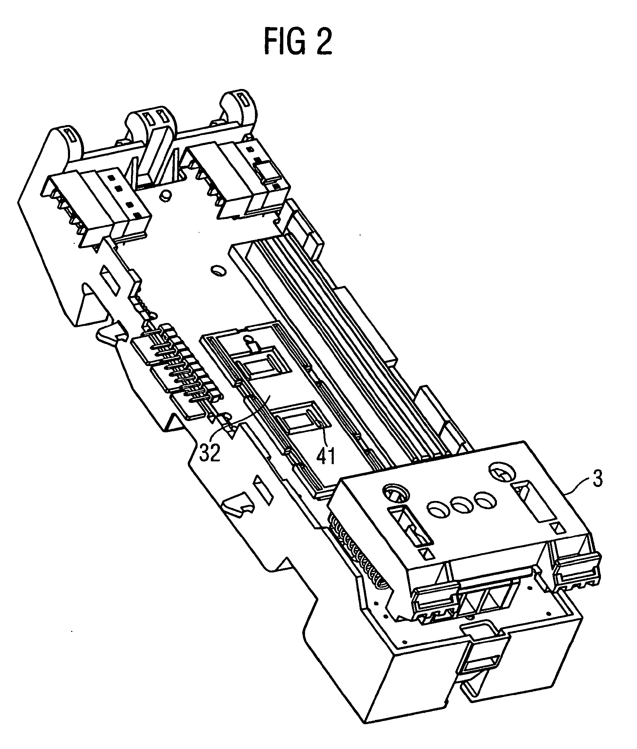

FIG 2 zeigt ein Terminalmodul 1 mit Riegel 3 in perspektivischer Draufsicht. Die obere Abdeckung bzw. das Oberteil des Terminalmoduls ist in dieser Abbildung nicht dargestellt, so dass der unter dem Oberteil liegende Schaltschieber 32, welcher die Kontakte 4 mit dem Riegel 3 verbindet, sichtbar wird. Am Schaltschieber 32 sind Kontaktfedern 41 angebracht, welche die elektrischen Kontakte 4 öffnen und schließen.

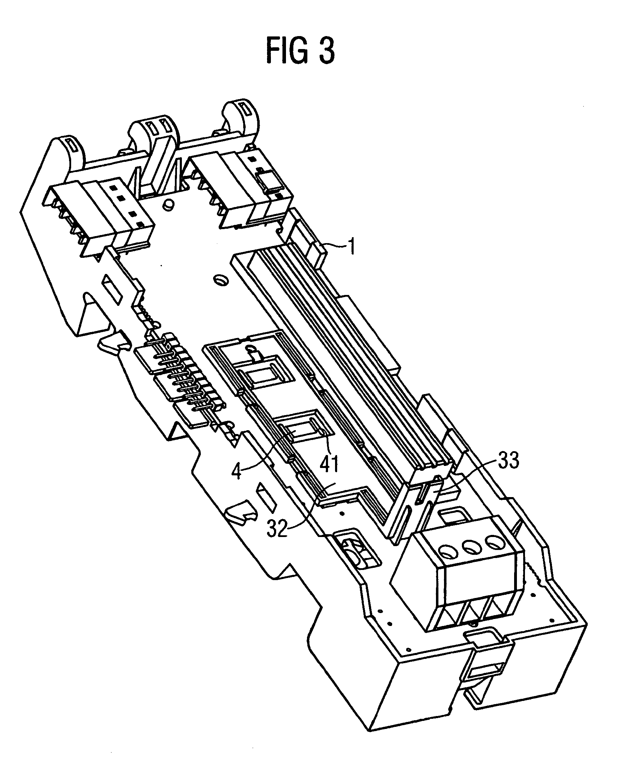

FIG 3 zeigt dieselbe Darstellung wie FIG 2, wobei der Riegel 3 in FIG 3 nun ebenfalls nicht dargestellt ist. Der Schaltschieber 32 weist einen nach oben gebogenen Abschnitt 33 auf, der unter den Riegel 3 greift und mit diesem verbunden ist.

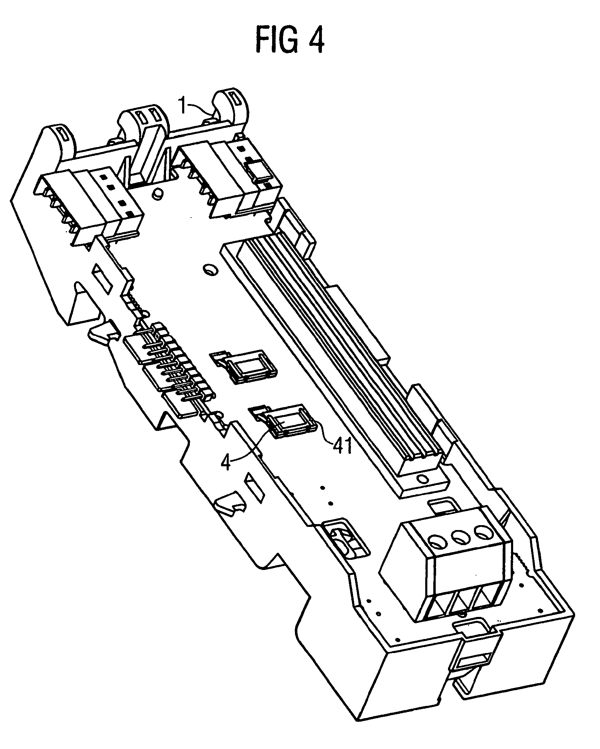

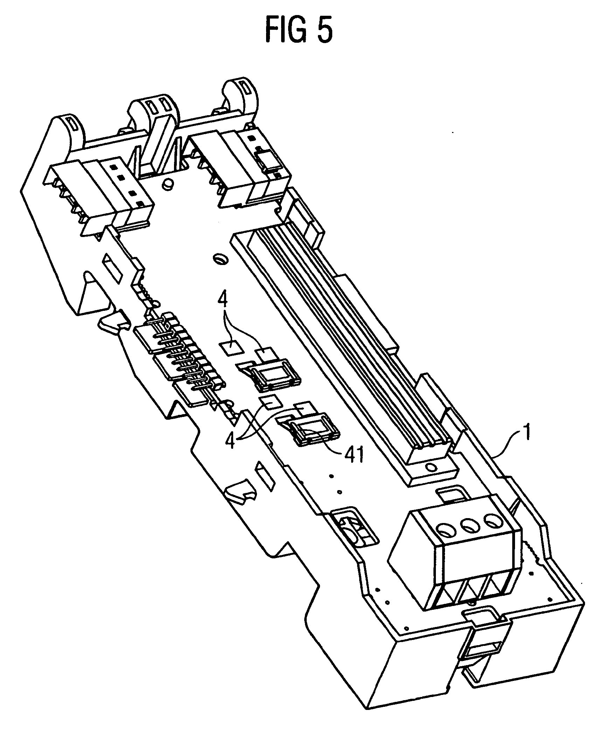

FIG 4 zeigt ein Terminalmodul 1 ohne Riegel 3 und ohne Schaltschieber 32 mit elektrischen Kontakten 4 im geschlossenen Zustand. Die elektrischen Kontakte 4 sind in FIG 5 im geöffneten Zustand dargestellt.

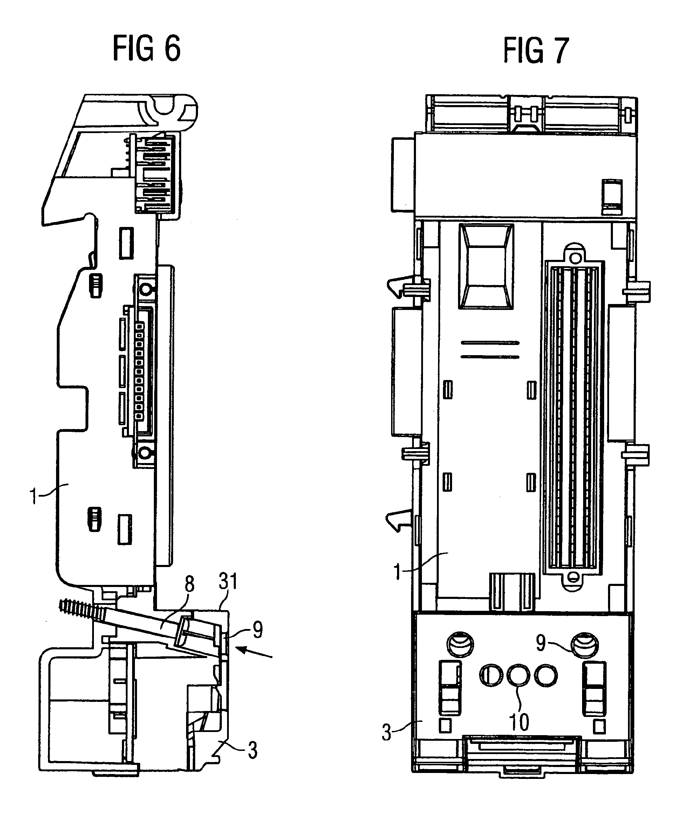

FIG 6 zeigt ein Terminalmodul 1 mit einem verschiebbaren Riegel 3 in Seitenansicht. Das Terminalmodul 1 wird mittels als Schrauben ausgebildeten Befestigungsmitteln 8 auf einer Tragschiene befestigt. Als Befestigungsmittel können auch andere Formen verwendet werden, wie beispielsweise zylinderförmige Hülsen, die bei einer Drehung von geringer Gradzahl (bsp. ¼ Drehung) in ein entsprechendes Widerlager greifen; ebenso sind Clips vorstellbar, die das Terminalmodul 1 an der Tragschiene befestigen. Die Befestigungsmittel 8 sind über in dem Riegel 3 vorhandene Öffnungen 9 für einen Bediener zugänglich. Hierbei sind die Öffnungen wie in FIG 7 dargestellt mit einer schräg nach unten ausgebildeten Neigung realisiert.

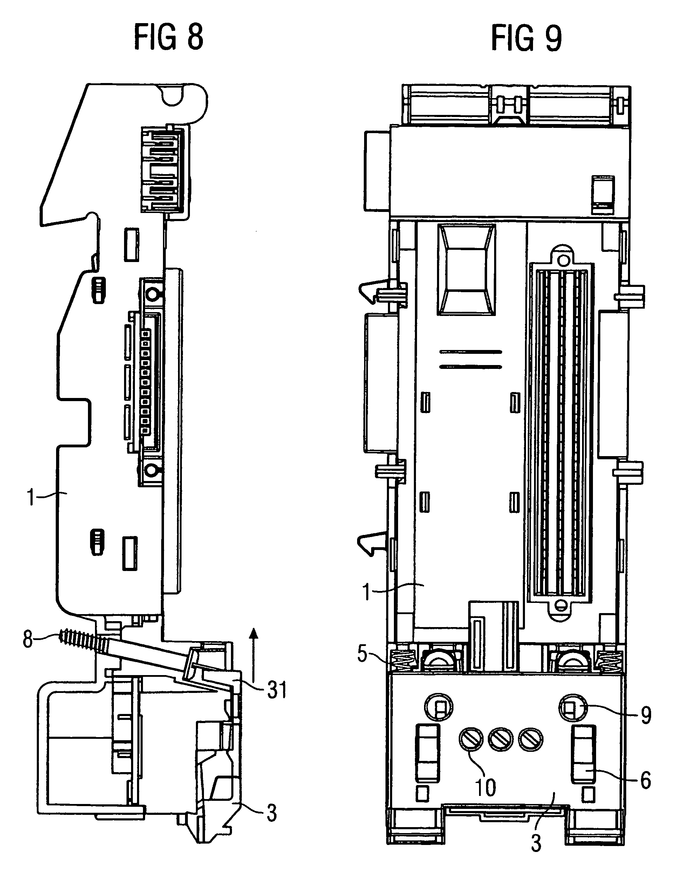

FIG 8 zeigt ein befestigtes Terminalmodul 1 in Seitenansicht. Die Schraube 8 ist in der Figur bereits fest angezogen und somit ist das Terminalmodul 1 fest an der Tragschiene angebracht. In diesem Zustand lässt sich der Riegel 3, welcher an einem Ende einen nasenartigen Vorsprung 31 aufweist, welcher sich nur über die Schraube 8 schieben lässt, wenn die Schraube vollständig angezogen ist.

Lässt sich der Riegel nicht über die Schraube 8 schieben, so kann der Aufschwenkvorgang eines PS-Moduls 2 nicht stattfinden, weil die Rasthaken des PS-Moduls 2 nicht derart in die Öffnungen 6 des Riegels eingeführt werden können, dass sie vollständig einhaken. Auf diese Wiese wird ein Aufschwenken eines PS-Moduls 2 auf ein nicht vollständig befestigtes Terminalmodul 1 unterbunden.

FIG 9 zeigt das befestigte Terminalmodul 1 mit Riegel 3 in Draufsicht. Der Riegel 3 kann jetzt gegen die Druckfedern 5 nach oben geschoben werden. Anstelle der abgebildeten Druckfedern sind auch andere Formen des Widerlagers möglich. Insbesondere können unterschiedliche Anzahlen von Druckfedern 5 verwendet werden. In diesem befestigten Zustand sind dritte Öffnungen 10 zur Bedienung einer Anschlussklemme 1 für den Bediener des Geräts zugänglich.

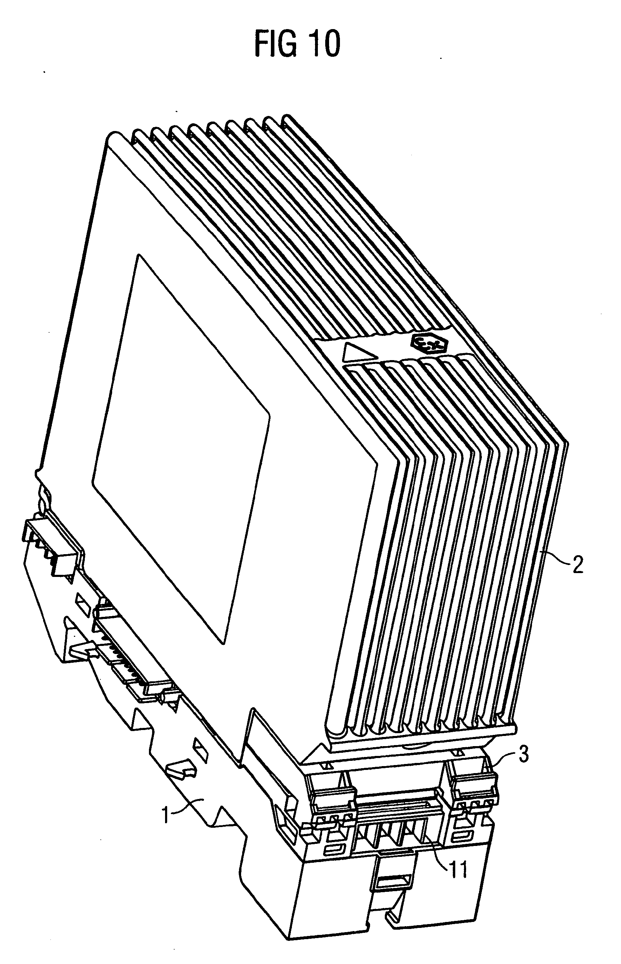

FIG 10 zeigt ein Terminalmodul 1 mit aufgerastetem PS-Modul 2. Die Öffnungen 10 für die Bedienung der Anschlussklemme 11 und auch die Öffnungen 9 für die Bedienung der Befestigungselemente 8 sind in diesem Zustand für den Bediener nicht mehr zugänglich.

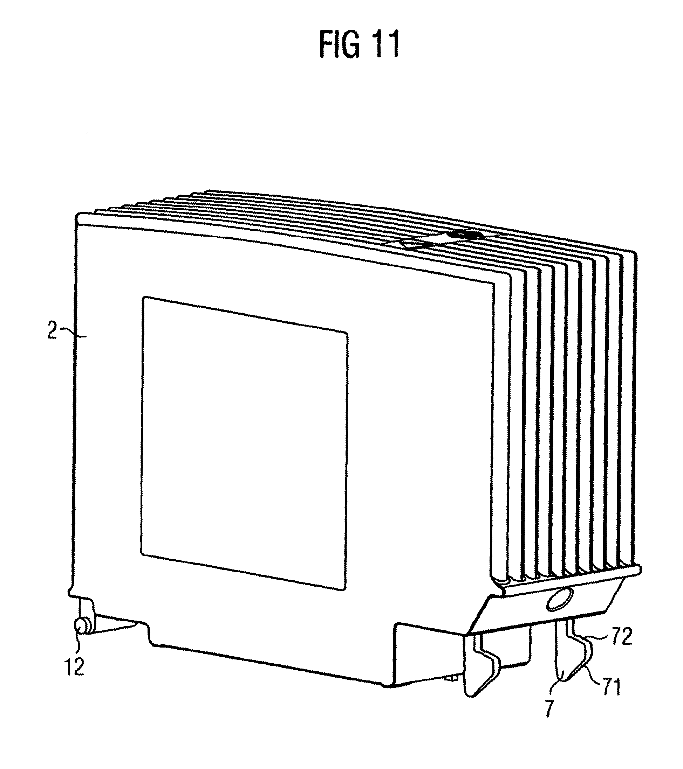

FIG 11 zeigt ein nicht eingehängtes PS-Modul 2. Das Modul 2 weist einen oder mehrere Rasthaken 7 auf, der/die in eine Öffnung 6 des Riegels 3 auf dem Terminalmodul 1 eingeführt werden. Die Rasthaken weisen eine spezifische Form auf, die beim Einschwenken auf ein Terminalmodul 1 zu einer Verschiebung des Riegels 3 auf dem Terminalmodul 1 führen und nach vollständigem Einschwenken zu einer Arretierung des PS-Moduls 2 auf dem Terminalmodul 1 führen. Dabei schiebt die erste Flanke 71 des Rasthakens den Riegel 3 beim Einschwenken der Stromversorgung 2 nach vorn. Am Ende des Einschwenkvorgangs schiebt sich der Riegel 3 über die zweite Flanke 72 des Rasthakens 7 und arretiert das PS-Modul 2.

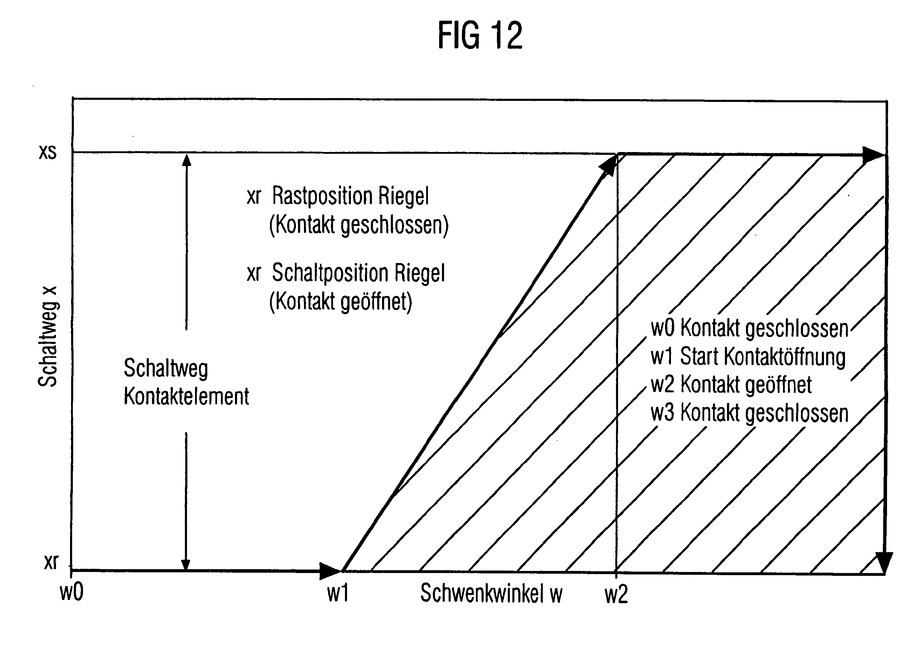

FIG 12 stellt den Schaltweg XS, den Verlauf der Schaltkurve in Abhängigkeit vom Schwenkwinkel W des PS-Moduls 2 und den Rastwinkel WR dar. Schaltweg, Verlauf von Schaltkurve und Rastwinkel sind von der geometrischen Form des Rasthakens 7 abhängig. Sie können somit auf das Kontaktverhalten der stromführenden Stifte des Steckverbinders zwischen PS-Modul 2 und Terminalmodul 1 abgestimmt werden. In der Rastposition XR wird das PS-Modul 2 über den Riegel 3 kraft- und formschlüssig mit dem Terminalmodul 1 verbunden. Die notwendigen Arretierungskräfte werden mit den Befestigungsmitteln bzw. der Druckfeder 8 erzeugt, welche während des Einschwenkvorganges für eine definierte Position des Riegels 3 sorgt. Auf die sicherheitstechnischen Funktionen des Riegels 3 und damit auch auf die des elektrischen Kontaktes hat die Druckfeder 8 keinen Einfluss.

Im folgenden wird kurz der Funktionsablauf in Abhängigkeit vom Schwenkwinkel w des Elektronikmoduls 2 beim Stecken beschrieben:
- Schwenkwinkel: Funktionsablauf/-weise
- w0 bis w1: Der Schalter im Terminalmodul 1 ist geschlossen und der Riegel 3 befindet sich in der Raststellung xr. Der Schalter besteht aus federnden Laschen am Kontaktelement 4 und entsprechenden Kontaktflächen auf der Leiterplatte.
- w1 bis w2: Der Riegel 3 wird gegen die Kraft der Druckfeder 8 in Richtung x entlang der durch den Rasthaken bzw. Schaltnocken 7 beschriebenen Kurve verschoben. Das Kontaktelement 4 ist mechanisch mit den Riegel 3 verbunden und bewegt sich deshalb ebenfalls linear in Richtung x. Dabei wird der Schalter geöffnet.
- w2: Der Schalter im Terminalmodul 1 ist sicher geöffnet. Zwischen den stromführenden Stiften des Steckverbinders, welcher die elektrische Verbindung zwischen Terminalmodul 1 und PS-Modul 2 bildet, sind bei diesen Schwenkwinkel die entsprechenden Kriech- und Luftstrecken noch so groß, dass kein Zündfunke oder Lichtbogen entstehen kann.
- w2 bis wr: Der Schalter im Terminalmodul 1 bleibt geöffnet. Alle Stiftkontakte des Steckverbinders werden eingeführt.
- wr: Der Riegel 3 wird durch die Kraft der Druckfeder 8 entgegengesetzt zur Richtung x bewegt. Terminalmodul 1 und PS-Modul 2 werden über den Riegel 3 kraft- und formschlüssig verbunden. Der Schalter im Terminalmodul 1 wird geschlossen. Das PS-Modul ist betriebsbereit.

Beim Ziehen des PS-Moduls 2 läuft der beschriebene Funktionsablauf in umgekehrter Reihenfolge ab. Der Riegel 3 wird mittels eines Werkzeuges (z.B. Schraubenzieher) aus der Raststellung xr in die Schaltstellung xs gezogen.

Die Erfindung betrifft zusammenfassend ein Terminalmodul 1 zur sicherheitstechnischen Verriegelung einer Baugruppe bzw. eines PS-Moduls 2 an dem Terminalmodul. Die Baugruppe 2 wird auf das Terminalmodul 1 aufgeschwenkt. Das Terminalmodul 1 verfügt über einen verschiebbaren Riegel 3 zur Befestigung der Baugruppe 2 am Terminalmodul 1. Während des Aufschwenkens ist eine Abschaltung elektrischer Kontakte gewährleistet.

## Patentansprüche

1. Terminalmodul (1) zur Aufnahme mindestens einer Baugruppe (2), insbesondere eines Stromversorgungsmoduls,
- mit einem verschiebbaren Riegel (3) zur mechanischen Arretierung der Baugruppe (2) im Betriebszustand, wobei der Riegel (3) beim Ziehen und/oder Stecken der Baugruppe (2) linear verschiebbar ist und
- mit elektrischen Kontakten (4) für die Baugruppe (2), wobei die elektrischen Kontakte (4) mit dem Riegel (3) derart verbunden sind, dass die elektrischen Kontakte (4) beim Ziehen und/oder Stecken der Baugruppe (2) geöffnet werden,
**dadurch gekennzeichnet,**
**dass** ein Widerlager (5), nämlich eine Druckfeder vorgesehen ist, wobei der Riegel (3) gegen eine durch das Widerlager (5) erzeugte Kraft verschiebbar ist.

2. Terminalmodul nach Anspruch 1,
**dadurch gekennzeichnet,**
**dass** ein Schaltschieber (32) zur Verbindung der elektrischen Kontakte mit dem Riegel vorgesehen ist.

3. Terminalmodul nach einem der vorhergehenden Ansprüche,
**dadurch gekennzeichnet,**
**dass** der Riegel (3) mindestens eine erste Öffnung (6) zur Aufnahme eines Rasthakens (7) einer Baugruppe (2) aufweist.

4. Terminalmodul nach Anspruch 3,
**dadurch gekennzeichnet,**
**dass** die mindestens eine erste Öffnung (6) des Riegels (3) als Nockenbahn ausgebildet ist, so dass das Aus- bzw. Einführen des Rasthakens (7) beim Ziehen und/oder Stecken der Baugruppe (2) die Verschiebung des Riegels (3) bewirkt.

5. Terminalmodul nach einem der vorhergehenden Ansprüche,
**dadurch gekennzeichnet,**
**dass** Befestigungsmittel (8) zur Befestigung des Terminalmoduls (1) auf einer Tragschiene vorgesehen sind, wobei die Befestigungsmittel (8) derart angeordnet sind, dass der Riegel (3) nur im befestigten Zustand verschiebbar ist.

6. Terminalmodul nach Anspruch 5,
**dadurch gekennzeichnet,**
**dass** die Befestigungsmittel (8) als Schrauben ausgebildet sind.

7. Terminalmodul nach Anspruch 5 oder 6,
**dadurch gekennzeichnet,**
**dass** der Riegel (3) zweite Öffnungen (9) zur Bedienung der Befestigungsmittel (8) aufweist.

8. Terminalmodul nach einem der vorhergehenden Ansprüche,
**dadurch gekennzeichnet,**
**dass** der Riegel (3) dritte Öffnungen (10) aufweist, wobei die dritten Öffnungen (10) nur im befestigten Zustand, wenn der Riegel (3) verschiebbar ist, zugänglich sind.

9. Terminalmodul nach Anspruch 8,
**dadurch gekennzeichnet,**
**dass** die dritten Öffnungen (10) zur Bedienung einer elektrischen Anschlussklemme (11) vorgesehen sind.

10. Terminalmodul nach Anspruch 8 oder 9,
**dadurch gekennzeichnet,**
**dass** im Betriebszustand die gesteckte Baugruppe (2) zur Abdeckung der dritten Öffnungen (10) vorgesehen ist.

## Claims

1. Terminal module (1) for accommodating at least one subassembly (2), in particular a power supply module,
- having a sliding catch (3) for mechanical retention of the subassembly (2) in the operating state, where the catch (3) can move linearly when pulling out and/or plugging in the subassembly, and
- having electrical contacts (4) for the subassembly (2), where the electrical contacts (4) are connected to the catch (3) in such a way that the electrical contacts (4) are opened when pulling out and/or plugging in the subassembly (2)
**characterised in that**
a thrust piece (5), namely a compression spring, is provided, with the catch (3) being able to move against a force produced by the thrust piece (5).

2. Terminal module according to claim 1,
**characterised in that**
a switching slide (32) is provided for connecting the electrical contacts to the catch.

3. Terminal module according to one of the preceding claims,
**characterised in that**
the catch (3) has at least one first opening (6) for receiving a hooked catch (7) of a subassembly (2)

4. Terminal module according to claim 3,
**characterised in that**
the at least one first opening (6) in the catch (3) is implemented as a cam so that the extraction or insertion of the hooked catch (7) when pulling out and/or plugging in the subassembly (2) produces the movement of the catch (3).

5. Terminal module according to one of the preceding claims,
**characterised in that**
fixing means (8) are provided for fixing the terminal module (1) on a mounting rail, the fixing means (8) being arranged in such a way that the catch (3) can only be moved in the fixed state.

6. Terminal module according to claim 5,
**characterized in that**
the fixing means (8) are embodied as screws.

7. Terminal module according to claim 5 or 6,
**characterized in that**
the catch (3) has second openings (9) for operating the fixing means (8).

8. Terminal module according to one of the preceding claims,
**characterized in that**
the catch (3) has third openings (10), the third openings (10) only being accessible in the fixed state, when the catch (3) can be moved.

9. Terminal module according to claim 8,
**characterized in that**
the third openings (10) are provided for operating an electrical terminal (11).

10. Terminal module according to claim 8 or 9,
**characterized in that**
in the operating state, the plugged-in subassembly (2) is provided to cover the third openings (10).

## Revendications

1. Module de terminaison (1) pour recevoir au moins un sous-ensemble (2), en particulier un module d'alimentation électrique, comprenant
- un verrou mobile (3) pour le verrouillage mécanique du sous-ensemble (2) à l'état opérationnel, dans lequel le verrou (3) est mobile de façon linéaire lorsque le sous-ensemble (2) est retiré et/ou enfiché, et
- des contacts électriques (4) pour le sous-ensemble (2), dans lequel les contacts électriques (4) sont reliés au verrou (3) de telle sorte que les contacts électriques (4) sont ouverts lorsque le sous-ensemble est retiré et/ou enfiché,
**caractérisé en ce qu'**une contre-butée (5) notamment un ressort de pression, est prévue, le verrou (3) étant mobile à l'encontre d'une force produite par la contre-butée (5).

2. Module de terminaison selon la revendication 1, **caractérisé en ce qu'**un curseur de commutation (32) est prévu pour relier les contacts électriques au verrou.

3. Module de terminaison selon l'une quelconque des revendications précédentes, **caractérisé en ce que** le verrou (3) présente au moins une première ouverture (6) pour recevoir un crochet d'enclenchement (7) d'un sous-ensemble (2).

4. Module de terminaison selon la revendication 3, **caractérisé en ce que** ladite au moins une ouverture (6) du verrou (3) est réalisée comme un chemin de came, de sorte que le fait de sortir ou d'entrer le crochet d'enclenchement (7) provoque le déplacement du verrou (3) lorsque le sous-ensemble (2) est retiré et/ou enfiché.

5. Module de terminaison selon l'une quelconque des revendications précédentes, **caractérisé en ce que** des moyens de fixation (8) sont prévus pour fixer le module de terminaison (1) sur un rail de support, les moyens de fixation (8) étant disposés de telle sorte que le verrou est mobile seulement à l'état fixé.

6. Module de terminaison selon la revendication 5, **caractérisé en ce que** les moyens de fixation (8) sont réalisés comme des vis.

7. Module de terminaison selon la revendication 5 ou 6, **caractérisé en ce que** le verrou (3) présente des deuxièmes ouvertures (9) pour commander les moyens de fixation (8).

8. Module de terminaison selon l'une quelconque des revendications précédentes, **caractérisé en ce que** le verrou (3) présente des troisièmes ouvertures (10), les troisièmes ouvertures (10) étant accessibles à l'état fixé, seulement lorsque le verrou (3) est mobile.

9. Module de terminaison selon la revendication 8, **caractérisé en ce que** les troisièmes ouvertures (10) sont prévues pour la commande d'une borne de connexion électrique (11).

10. Module de terminaison selon la revendication 8 ou 9, **caractérisé en ce qu'**à l'état opérationnel, le sous-ensemble enfiché (2) est prévu pour recouvrir les troisièmes ouvertures (10).
